# FASCICULE DE BREVET EUROPEEN

(11) **EP 3 159 302 B1**
(45) Date de publication et mention de la délivrance du brevet: **08.01.2020**
(21) Numéro de dépôt: 16194901.1
(22) Date de dépôt: 20.10.2016
(51) Int. Cl.: B81C 1/00

(54) **PROCEDE D'ENCAPSULATION D'UN COMPOSANT MICROELECTRONIQUE**
EINKAPSELUNGSVERFAHREN EINES MIKROELEKTRONISCHEN BAUTEILS
METHOD FOR ENCAPSULATING A MICROELECTRONIC COMPONENT

(30) Priorité: 21.10.2015 FR 1560031
(43) Date de publication de la demande: 26.04.2017
(73) Titulaire: COMMISSARIAT À L'ÉNERGIE ATOMIQUE ET AUX ÉNERGIES ALTERNATIVES, 75015 Paris (FR)
(72) Inventeur: REY, Patrice, 38430 ST JEAN DE MOIRANS (FR)
(74) Mandataire: Brevalex

(56) Documents cités:
- FR-A1- 2 970 116
- US-A1- 2010 258 882

## Description

### DOMAINE TECHNIQUE ET ART ANTÉRIEUR

L'invention porte sur un procédé d'encapsulation d'au moins un composant microélectronique. L'invention est avantageusement mise en œuvre pour réaliser une encapsulation collective à l'échelle d'un substrat de composants microélectroniques de type MEMS (Microsystème électromécanique, ou « MicroElectroMechanical System » en anglais) et/ou NEMS (Nanosystème électromécanique, ou « NanoElectroMechanical System » en anglais).

Les composants microélectroniques de type MEMS / NEMS sont très répandus et utilisés pour un grand nombre d'applications (automobile comme par exemple dans les systèmes de type airbag, médicale comme par exemple dans les pacemakers, militaire, aéronautique, téléphone portable, jeux vidéo, etc.) en raison de leur taille très petite, de leur coût faible et de leur bonne fiabilité. Par exemple, la plupart des smartphones, ou téléphones intelligents, comportent un capteur MEMS permettant la mesure de l'accélération, de la vitesse de rotation et du champ magnétique selon trois axes (capteur à neuf degrés de liberté). Les composants microélectroniques sensibles à ces grandeurs comportent une ou plusieurs microstructures mobiles. Par exemple, un accéléromètre comporte une masse mobile dont le déplacement, sous l'effet d'une accélération, agit sur des éléments de détection (de type capacitif, piézorésistif, etc.).

Ces microstructures mobiles, très fragiles, doivent être encapsulées afin de subir sans encombre les étapes de fabrication ultérieures à leur libération (notamment l'étape de découpe en puces individuelles du substrat sur lequel sont réalisés les composants microélectroniques) et pour être protégées du milieu extérieur lors de leur utilisation. L'encapsulation consiste à enfermer le composant microélectronique dans une cavité délimitée entre un capot et le substrat sur lequel le composant microélectronique est réalisé. Cette cavité est en général fermée hermétiquement sous gaz neutre ou sous vide afin d'éviter toute réaction chimique entre le milieu extérieur et le composant microélectronique. L'herméticité de la cavité permet de garantir la stabilité de l'atmosphère emprisonnée dans la cavité. L'herméticité permet aussi de garantir la stabilité de la pression à l'intérieur de la cavité, ce qui peut être un facteur déterminant pour le bon fonctionnement du composant microélectronique.

Une des solutions les plus répandues pour encapsuler ce type de composant microélectronique consiste à reporter sur le substrat servant de support au composant un capot usiné dans un second substrat. Le report du capot sur le substrat comportant les composants microélectroniques se fait collectivement à l'échelle du wafer, c'est-à-dire simultanément pour tous les composants microélectroniques présents sur le substrat. Il existe différents procédés de scellement étanche ou hermétique pour solidariser de manière étanche ou hermétique le capot au substrat support, comme par exemple le scellement eutectique qui met en jeu une réaction entre deux matériaux (par exemple l'or et le silicium, ou l'aluminium et le germanium) pour former un alliage, le scellement anodique, le scellement à base de polymère, etc. Les documents US 2014/0131820 A1 et DE 10 2011 077 933 A1 décrivent de telles encapsulations.

Ce type d'encapsulation par report de capot présente toutefois plusieurs inconvénients. Tout d'abord, l'épaisseur de la structure d'encapsulation obtenue est importante. En effet, l'épaisseur du capot est généralement égale à celle d'un substrat semi-conducteur classique, soit environ 750 µm pour un substrat standard de diamètre égal à 200 mm. Cette épaisseur peut être réduite après le scellement par la mise en œuvre d'un amincissement du capot. Néanmoins, pour des raisons de tenue mécanique, cette épaisseur peut difficilement être réduite à moins de 200 µm. De plus, un tel procédé est complexe à mettre en œuvre car le nombre d'étapes nécessaires à la réalisation du capot peut être parfois élevé.

Pour résoudre les problèmes d'encombrement en épaisseur liés au report d'un substrat pour former le capot, une solution consiste à encapsuler le composant microélectronique par un capot formé par un dépôt de couche mince. Le procédé consiste à recouvrir chaque composant microélectronique d'un matériau sacrificiel lui-même recouvert d'une couche mince d'encapsulation qui forme le capot. Le matériau sacrificiel est ensuite gravé via une ouverture pratiquée à travers la couche d'encapsulation. Le résultat de ces opérations est la formation, au-dessus du composant microélectronique, d'une cavité délimitée par le capot. Le trou par lequel est effectuée la gravure du matériau sacrificiel peut être bouché ensuite hermétiquement par un dépôt adéquat.

Le document US 6 472 739 B1 décrit un tel procédé d'encapsulation par couche mince. Il est notamment décrit que le matériau sacrificiel peut être structuré pour ne couvrir qu'une partie du composant microélectronique, laissant par exemple à découvert ses plots de contact. Cette structuration peut être faite par photolithographie si le matériau sacrificiel est un matériau photosensible.

Un tel procédé a toutefois plusieurs inconvénients. Tout d'abord, le matériau sacrificiel étant dispensé directement sur les microstructures mobiles du composant, cela peut entraîner des détériorations de ces microstructures. Le matériau sacrificiel, qui est par exemple une résine photosensible, s'infiltre dans le composant microélectronique, notamment dans les entrefers et sous les structures mobiles, ce qui peut rendre son élimination très difficile. Pour cette raison, ce procédé n'est pas adapté à l'encapsulation de composants d'épaisseur importante, par exemple supérieure ou égale à environ 3 µm.

Le document WO 2012/093105 A1 décrit également un procédé d'encapsulation d'un composant microélectronique par couche mince. Dans ce procédé, un renfort du capot est réalisé par un dépôt d'une couche épaisse pour tenir les conditions dans lesquelles une opération de surmoulage est réalisée ultérieurement (pression comprise entre environ 100 et 200 bars, température comprise entre environ 150°C et 200°C pendant quelques dizaines de secondes). Le matériau sacrificiel est gravé depuis la face arrière du substrat. Là encore, du fait que le composant est réalisé avant le capot mince, la dispense de la couche de matériau sacrificiel peut causer des dégâts irréversibles sur le composant microélectronique, notamment sur les structures mobiles du composant. De plus, le matériau sacrificiel est difficilement éliminé depuis la face arrière du substrat si la structure du composant microélectronique comporte par exemple des tranchées profondes et étroites.

Le document US 2008/0290494 A1 décrit un procédé d'encapsulation dans lequel la libération de la structure mobile d'un composant microélectronique est réalisée depuis la face arrière du substrat. Le procédé consiste à graver la structure mobile du composant microélectronique dans la couche superficielle de silicium d'un substrat SOI (silicium sur isolant, ou « Silicon On Insulator » en anglais) puis à remplir les tranchées gravées par un matériau diélectrique tel que du SiO₂, du Si₃N₄, du verre PSG (verre de silicate dopé au phosphore, ou « PhosphoSilicate Glass » en anglais), du verre BPSG (verre de silicate dopé au bore et au phosphore, ou « BoroPhosphoSilicate Glass » en anglais), ou du verre de spin (« spin on glass » en anglais), de manière à pouvoir continuer le procédé (report du capot de protection, réalisation des connexions électriques, etc.) sur une surface plane. Toutefois, le remplissage de tranchées de largeur variable et de profondeur supérieure à quelques microns par le matériau diélectrique pose de gros problèmes de mise en œuvre technologique car ces dépôts doivent être très conformes et suivre au mieux le relief des surfaces sur lesquelles les dépôts sont réalisés, et le matériau déposé doit avoir une épaisseur égale au moins à la moitié de la plus large des tranchées (ce qui n'est plus raisonnablement possible au-delà de quelques microns) et doit pouvoir être gravé sélectivement par rapport au silicium à partir duquel le composant microélectronique est réalisé.

Le procédé d'encapsulation décrit dans le document US2010/258882 décrit un procédé d'encapsulation comprenant la réalisation d'une portion de matériau sacrificiel sur une face avant d'un premier substrat. Si la couche 105 bloque l'accès à la couche de matériau sacrificiel, elle ne l'encapsule pas. Après différentes étapes, une partie de matériau sacrificiel est éliminée par gravure depuis la face arrière du composant microélectronique. Un tel composant est ensuite destiné à être solidarisé avec un deuxième substrat.

Le SiO₂ est le matériau le plus couramment utilisé comme matériau sacrificiel pour la réalisation de capots minces. Des dépôts conformes de SiO₂ de plusieurs microns d'épaisseur ne sont toutefois pas envisageables. L'oxydation thermique du silicium permet d'obtenir une couche de SiO₂ d'une excellente conformité. Cependant, des épaisseurs supérieures à 2 ou 3 microns ne peuvent pas être obtenues par une telle oxydation thermique. De plus, l'oxydation thermique s'accompagne d'une consommation du silicium modifiant les dimensions critiques de la structure mécanique formée de ce silicium.

Le Si₃N₄ est un matériau peu utilisé comme matériau sacrificiel. C'est un matériau très contraint lorsqu'il est sous sa forme stœchiométrique et les épaisseurs déposées ne dépassent pas en général 2 microns voire 1 micron. Il est de plus résistant à l'acide fluorhydrique (HF) et les vitesses de gravure avec l'acide phosphorique, agent de gravure généralement utilisé pour éliminer le Si₃N₄, sont très faibles.

Enfin, les matériaux de type verre sont très peu conformes et laissent des résidus lorsqu'ils sont gravés avec des solutions à base de HF.

Ainsi, aucun des matériaux sacrificiels ci-dessus n'est adapté pour la mise en œuvre d'une encapsulation telle que décrite dans le document US 2008/0290494 A1.

Dans les procédés d'encapsulation décrits dans les documents précédemment cités, le capot mince est réalisé après la gravure du composant microélectronique dans le substrat, parfois même après l'étape de libération des parties mobiles du composant, ce qui pose dans tous les cas des problèmes technologiques liés à la planarisation de la surface devant être réalisée pour continuer la réalisation du capot.

L'encapsulation par packaging couche mince permet donc de réduire l'encombrement de la structure d'encapsulation du composant microélectronique. Cependant, les techniques connues de mise en œuvre de ce type d'encapsulation ne sont pas applicables lorsque le composant microélectronique comporte des parties mobiles et/ou lorsque sa topologie est importante.

### EXPOSÉ DE L'INVENTION

Un but de la présente invention est de proposer un procédé d'encapsulation d'un composant microélectronique ne présentant pas les inconvénients précédemment décrits en lien avec les procédés de l'art antérieur, c'est-à-dire :
- permettant la réalisation d'une structure d'encapsulation ayant un faible encombrement,
- supprimant les risques de détérioration du composant microélectronique liés au dépôt d'un matériau sacrificiel,
- facilitant le dépôt et l'élimination du matériau sacrificiel,
- qui soit adapté à l'encapsulation de composants microélectroniques d'épaisseur importante, par exemple supérieure ou égale à environ 3 µm, et/ou présentant des structurations (par exemple des tranchées) de dimensions importantes, par exemple supérieures ou égales à plusieurs dizaines de microns.

Pourcela, la présente invention propose un procédé d'encapsulation d'au moins un composant microélectronique comportant au moins la mise en œuvre des étapes suivantes :
- réalisation d'au moins une portion de matériau sacrificiel sur une face avant d'un premier substrat dans lequel le composant microélectronique est apte à être réalisé ;
- réalisation d'au moins un capot encapsulant au moins la portion de matériau sacrificiel ;
- réalisation du composant microélectronique par gravure du premier substrat depuis une face arrière du premier substrat (face opposée à la face avant du premier substrat), telle qu'au moins une partie du composant microélectronique soit disposée face à la portion de matériau sacrificiel et que la portion de matériau sacrificiel soit accessible depuis une face arrière du composant microélectronique ;
- élimination de la portion de matériau sacrificiel par gravure depuis la face arrière du composant microélectronique ;
- solidarisation de la face arrière du composant microélectronique avec un deuxième substrat.

L'expression « composant microélectronique » est utilisée ici pour désigner tout type de dispositif microélectronique, et notamment des dispositifs MEMS et/ou NEMS.

Ce procédé d'encapsulation permet la réalisation d'une structure d'encapsulation ayant un faible encombrement du fait que le capot peut être réalisé par le dépôt d'une couche d'encapsulation.

Du fait que le composant microélectronique est réalisé dans le premier substrat après la réalisation de la portion de matériau sacrificiel sur laquelle le capot est formé, les risques de détérioration du composant microélectronique liés au dépôt d'un matériau sacrificiel sur le composant microélectronique sont supprimés. Cela facilite également le dépôt et l'élimination de ce matériau sacrificiel puisqu'il n'est pas nécessaire de déposer ce matériau sacrificiel dans des parties difficilement accessibles du composant microélectronique, comme par exemple dans des entrefers ou sous certaines parties du composant microélectronique. Il en découle que ce procédé d'encapsulation est bien adapté à l'encapsulation de composants microélectroniques d'épaisseur importante et/ou présentant des structurations de dimensions importantes.

Ce procédé permet avantageusement d'encapsuler des composants microélectroniques correspondant à des structures MEMS à forte topologie comportant typiquement des structures mobiles en silicium gravées par la mise en œuvre d'une gravure de type DRIE (gravure ionique réactive profonde, ou « Deep Reactive Ion Etching » en anglais) sur des profondeurs de plusieurs microns, voire plusieurs dizaines ou centaines de microns.

En outre, le fait que le composant microélectronique soit réalisé dans le premier substrat après la réalisation de la portion de matériau sacrificiel sur laquelle le capot est formé facilite la mise en œuvre de l'élimination du matériau sacrificiel depuis la face arrière du composant microélectronique qui permet de conserver l'intégrité du capot réalisé (aucun trou de libération formé à travers le capot n'est nécessaire).

L'épaisseur de la structure d'encapsulation réalisée peut être très faible et est seulement limitée par des considérations de rigidité qui dépendent de nombreux facteurs (surface, type de composants, ...). Par exemple, avec un composant microélectronique de type MEMS d'épaisseur égale à environ 20 µm solidarisé sur un deuxième substrat correspondant à un circuit électronique de type ASIC (Circuit intégré à application spécifique, ou « Application-Specific Integrated Circuit » en anglais) aminci d'épaisseur égale à environ 100 µm, l'épaisseur totale de la structure d'encapsulation est égale à environ 120 µm.

Le capot encapsule au moins la portion de matériau sacrificiel, ce qui signifie que le capot est disposé sur la portion de matériau sacrificiel et recouvre également au moins une partie des parois latérales de la portion de matériau sacrificiel.

Ladite partie du composant microélectronique peut comporter au moins un élément mobile.

La gravure mise en œuvre pour réaliser le composant microélectronique dans le premier substrat peut former au moins une tranchée traversant toute l'épaisseur du premier substrat, peut délimiter ladite partie du composant microélectronique et peut former un accès à la portion de matériau sacrificiel depuis la face arrière du composant microélectronique. Ainsi, l'étape de réalisation du composant microélectronique sert également à former les accès pour graver ultérieurement la portion de matériau sacrificiel.

La solidarisation de la face arrière du composant microélectronique avec le deuxième substrat peut former au moins une liaison électrique entre au moins un élément d'interconnexion électrique du deuxième substrat et au moins une portion électriquement conductrice du composant microélectronique.

Dans ce cas, le deuxième substrat peut comporter au moins un circuit électronique apte à lire au moins un signal électrique délivré par le composant microélectronique.

La solidarisation de la face arrière du composant microélectronique avec le deuxième substrat peut être réalisée de manière hermétique telle qu'au moins ladite partie du composant microélectronique soit enfermée hermétiquement dans une cavité formée entre le capot et le deuxième substrat.

Le procédé peut comporter en outre, entre la réalisation du capot et la réalisation du composant microélectronique, la mise en œuvre des étapes suivantes :
- réalisation d'une poignée temporaire solidarisée au capot ;
- amincissement du premier substrat tel qu'une épaisseur restante du premier substrat corresponde à une épaisseur du composant microélectronique ;
et la poignée temporaire peut être désolidarisée du capot après la solidarisation de la face arrière du composant microélectronique avec le deuxième substrat. Ainsi, il est possible d'utiliser initialement un premier substrat dont l'épaisseur est supérieure à celle souhaitée du composant microélectronique.

De plus, le procédé peut comporter en outre, entre la solidarisation de la face arrière du composant microélectronique avec le deuxième substrat et la désolidarisation de la poignée temporaire, la mise en œuvre d'un amincissement du deuxième substrat.

La réalisation de la poignée temporaire peut comporter la mise en œuvre des étapes suivantes :
- dépôt d'une couche de solidarisation sur le capot et sur des parties de la face avant du premier substrat non recouvertes par le capot ;
- planarisation de la couche de solidarisation ;
- collage d'un substrat temporaire sur la couche de solidarisation.

Le procédé peut comporter en outre, avant la réalisation du capot, la réalisation d'au moins une couche de protection sur la face avant du premier substrat, et dans lequel :
- au moins une partie de la portion de matériau sacrificiel peut être disposée dans au moins une ouverture formée à travers la couche de protection ;
- le matériau de la couche de protection peut être apte à résister à la gravure mise en œuvre lors de l'élimination de la portion de matériau sacrificiel.

Le matériau de la couche de protection peut être apte à protéger la couche de solidarisation lors de la gravure mise en œuvre lors de l'élimination de la portion de matériau sacrificielle.

La couche de protection peut être réalisée sur la face avant du premier substrat avant la réalisation de la portion de matériau sacrificiel, et la réalisation de la portion de matériau sacrificiel peut comporter la mise en œuvre des étapes suivantes :
- dépôt d'au moins une première couche de matériau sacrificiel sur la couche de protection et dans ladite au moins une ouverture formée à travers la couche de protection ;
- planarisation de la première couche de matériau sacrificiel avec arrêt sur la couche de protection, formant au moins une portion restante de la première couche de matériau sacrificiel disposée dans ladite au moins une ouverture formée à travers la couche de protection ;
- dépôt d'au moins une deuxième couche de matériau sacrificiel sur ladite au moins une portion restante de la première couche de matériau sacrificiel et sur la couche de protection;
- gravure de la deuxième couche de matériau sacrificiel telle que des portions restantes de la deuxième couche de matériau sacrificiel définissent au moins une zone d'ancrage du capot au premier substrat et au moins une butée pour au moins un élément mobile du composant microélectronique, et telle qu'au moins une des portions restantes de la deuxième couche de matériau sacrificiel recouvre au moins en partie ladite au moins une portion restante de la première couche de matériau sacrificiel ;
et dans lequel la portion de matériau sacrificiel encapsulée par le capot correspond à ladite au moins une portion restante de la première couche de matériau sacrificiel et aux portions restantes de la deuxième couche de matériau sacrificiel.

La réalisation du capot peut comporter une étape de dépôt d'une couche d'encapsulation d'épaisseur inférieure à environ 10 µm, et avantageusement inférieure à environ 5 µm.

Le procédé peut être mis en œuvre de manière collective afin d'encapsuler simultanément plusieurs composants microélectroniques réalisés dans le premier substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

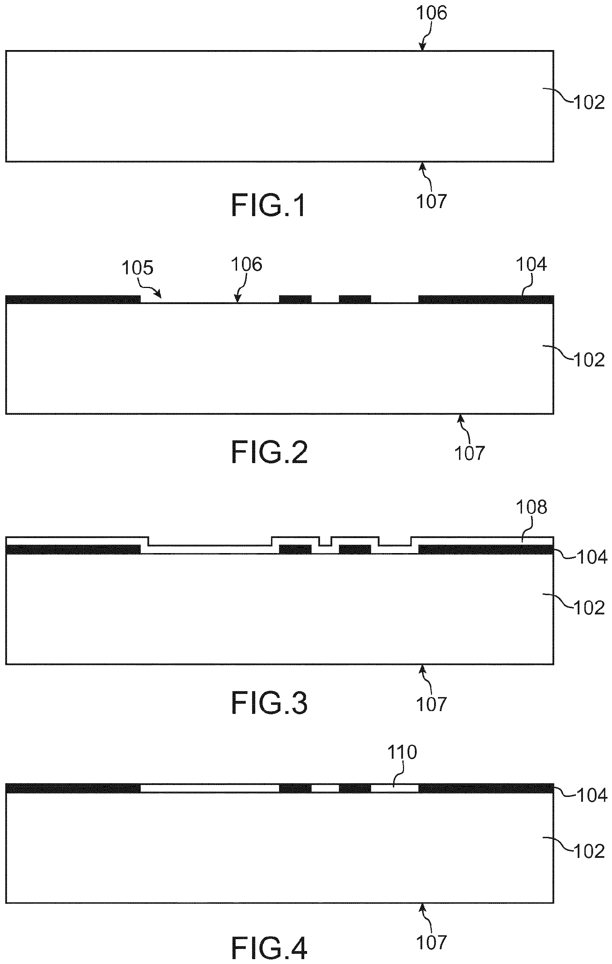

- les figures 1 à 18 représentent les étapes d'un procédé d'encapsulation d'un composant microélectronique, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère aux figures 1 à 18 qui représentent les étapes d'un procédé d'encapsulation d'un composant microélectronique 100 selon un mode de réalisation particulier.

Le procédé débute en utilisant un premier substrat 102, par exemple en semi-conducteur tel que du silicium, à partir duquel le composant microélectronique 100 va être réalisé (figure 1).

Une couche de protection 104 comportant un matériau résistant à au moins un agent de gravure qui sera utilisé par la suite pour graver un matériau sacrificiel qui servira à former la cavité dans laquelle le composant 100 sera encapsulé, est déposée sur une face avant 106 du premier substrat 102. La face avant 106 est plane, de même qu'une face arrière 107 du premier substrat 102. Par exemple, lorsque le matériau sacrificiel qui sera utilisé pour former la cavité correspond à du SiO₂ destiné à être gravé chimiquement par une solution d'acide fluorhydrique, la couche de protection 104 peut correspondre à une couche de Si₃N₄. L'épaisseur de la couche de protection 104 est par exemple comprise entre environ 0,2 µm et 1 µm. Des parties de la couche de protection 104 sont ensuite gravées (figure 2), formant un ou plusieurs des ouvertures 105 dans lesquelles du matériau sacrificiel est destiné à être disposé et qui sont destinées à former une partie de la cavité dans laquelle le composant 100 sera encapsulé.

Une première couche de matériau sacrificiel 108 est ensuite déposée de manière conforme sur la couche de protection 104, et sur les parties de la face avant 106 du premier substrat 102 non recouvertes par la couche de protection 104, c'est-à-dire dans les ouvertures 105 (figure 3). L'épaisseur de cette première couche de matériau sacrificiel 108 est supérieure ou égale à celle de la couche de protection 104 afin que les ouvertures 105 soient comblées par le matériau sacrificiel de la première couche 108. Le matériau sacrificiel de cette première couche 108 est choisi en fonction de l'agent de gravure qui sera utilisé par la suite pour former la cavité dans laquelle le composant 100 sera encapsulé. Le matériau de la première couche 108 est par exemple du SiO₂ qui sera gravé par une solution d'acide fluorhydrique, ou un polymère qui sera supprimé par gravure plasma O₂. De manière générale, le matériau sacrificiel de la première couche 108 peut être un matériau diélectrique, un polymère ou bien un métal.

Comme représenté sur la figure 4, une étape de planarisation est mise en œuvre afin de supprimer les parties de la première couche de matériau sacrificiel 108 qui ne sont déposées dans les ouvertures 105 et qui recouvrent la couche de protection 104. Cette planarisation peut être stoppée lorsque la face supérieure de la couche de protection 104 est atteinte. Seules des portions restantes 110 de matériau sacrificiel remplissant les ouvertures 105 sont donc conservées, ces portions restantes 110 formant avec la couche de protection 104 une couche plane recouvrant la face supérieure 106 du premier substrat 102. L'épaisseur des portions restantes 110 est donc égale à celle de la couche de protection 104.

En variante, au lieu de réaliser ces portions restantes 110 via un dépôt comme précédemment décrit en liaison avec la figure 3, il est possible que ces portions 110 soient obtenues via la mise en œuvre d'une oxydation thermique du semi-conducteur du substrat 102 à travers les ouvertures 105.

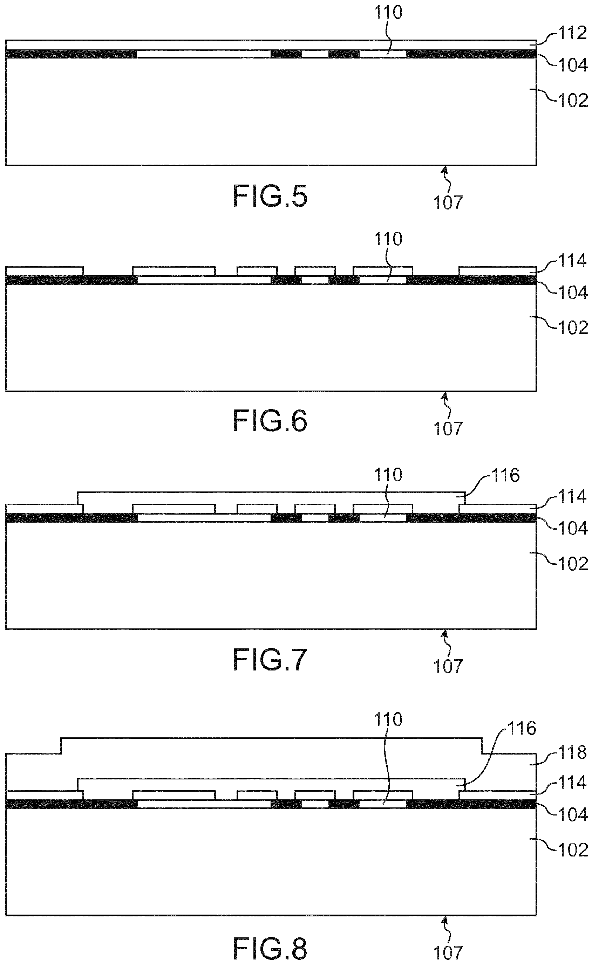

Une deuxième couche de matériau sacrificiel 112, comportant par exemple le même matériau sacrificiel que celui des portions 110, est ensuite réalisée, par exemple par dépôt, sur l'ensemble de la face avant de la structure précédemment réalisée, c'est-à-dire sur les portions restantes 110 et sur la couche de protection 104 (figure 5). L'épaisseur de cette deuxième couche 112 est choisie telle que la somme des épaisseurs de la deuxième couche 112 et des portions 110 soit sensiblement égale à la hauteur de l'espace vide souhaité au-dessus du composant 100 lorsqu'il sera encapsulé. L'épaisseur de la deuxième couche de matériau sacrificiel 112 est par exemple comprise entre environ 0,5 µm et 3 µm.

Sur la figure 6, la deuxième couche 112 est ensuite gravée afin que des portions restantes 114 de cette deuxième couche 112 définissent à côté d'elles une ou plusieurs futures zones d'ancrage du capot au premier substrat 102 (via la couche de protection 104) ainsi qu'une ou plusieurs butées pour un ou plusieurs éléments mobiles du composant 100. De plus, les portions restantes 114 de la deuxième couche de matériau sacrificiel 112 recouvrent au moins en partie les portions restantes 110 de la première couche de matériau sacrificiel 108 afin que l'agent de gravure qui sera utilisé par la suite puisse atteindre les portions restantes 114 depuis la face arrière du composant 100.

Le capot 116 est ensuite réalisé en déposant une couche d'encapsulation recouvrant notamment les portions restantes 114 et remplissant les ouvertures formées entre les portions 114 (figure 7). Les parties de la couche d'encapsulation déposées dans les ouvertures formées entre les portions 114 forment les zones d'ancrage et la ou les butées. La couche d'encapsulation peut être gravée afin de délimiter le capot 116 dans le plan principal du premier substrat 102 (plan parallèle aux faces 106, 107 du premier substrat 102). Le matériau du capot 116 est choisi tel qu'il résiste à l'agent de gravure qui sera utilisé pour graver les portions restantes 110 et 114. Par exemple, si cet agent de gravure correspond à une solution d'acide fluorhydrique et que le matériau sacrificiel est du SiO₂, le capot 116 peut comporter du silicium polycristallin. Lorsque le matériau sacrificiel est un polymère destiné à être gravé par un solvant organique ou par un plasma O₂, le capot 116 peut comporter du SiO₂. Le matériau choisi pour le capot 116 doit être tel que la gravure du matériau sacrificiel mise en œuvre ensuite soit suffisamment sélective par rapport au matériau du capot 116 sous peine de le graver complètement lors de la gravure du matériau sacrificiel. La couche d'encapsulation déposée comporte avantageusement une épaisseur comprise entre environ 0,5 µm et 10 µm.

Une poignée temporaire est ensuite réalisée sur le capot 116. Pour cela, comme représenté sur la figure 8, une couche de solidarisation 118, à laquelle un substrat temporaire est destiné à être solidarisé, est déposée sur la structure précédemment réalisée, recouvrant ainsi le capot 116 et les portions restantes 114 non recouvertes par le capot 116. Le matériau de la couche de solidarisation 118 est choisi tel qu'il puisse être gravé sélectivement par rapport au matériau du capot 116. Par exemple, lorsque le capot 116 est en silicium, le matériau de la couche de solidarisation 118 peut être du SiO₂, du Si₃N₄, ou encore du verre PSG ou BPSG. Ainsi, cette couche de solidarisation 118 comporte avantageusement un matériau similaire à celui des portions restantes 114, c'est-à-dire ici du SiO₂. L'épaisseur de cette couche de solidarisation 118 est au moins égale à la topologie formée par le capot 116. Par exemple, en considérant que la variation maximale de hauteur à la surface du substrat 102 est Δh, l'épaisseur de la couche de solidarisation 118 est avantageusement choisie égale à environ 1,5.Δh. De manière générale, l'épaisseur de la couche de solidarisation 118 est comprise entre environ 1 µm et 5 µm.

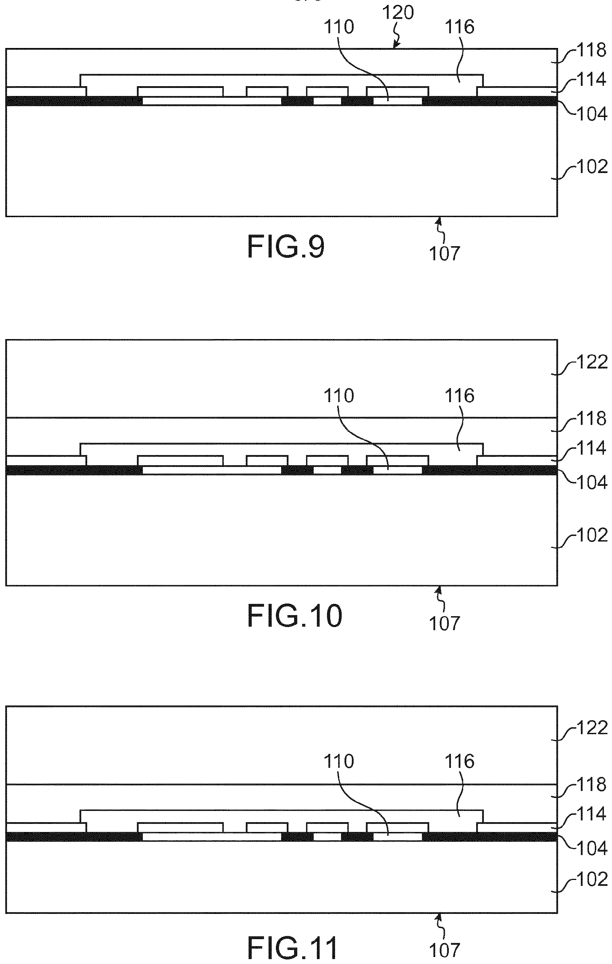

La couche de solidarisation 118 est ensuite planarisée par la mise en œuvre d'un polissage mécanochimique (CMP) telle que la face supérieure 120 de la couche de solidarisation 118 (face opposée à celle recouvrant le capot 116) soit plane et puisse être solidarisée à la future poignée temporaire (figure 9).

Comme représenté sur la figure 10, un substrat temporaire 122, correspondant ici à un substrat de semi-conducteur tel que du silicium, est solidarisé à la face supérieure 120 de la couche de solidarisation 118. Cette solidarisation du substrat temporaire 122 sur la face supérieure 120 de la couche de solidarisation 118 peut être réalisée par un collage direct (si les matériaux du substrat temporaire 122 et de la couche de solidarisation 118 sont compatibles avec la mise en œuvre d'un tel collage) ou par l'intermédiaire d'une couche adhésive interposée entre le substrat temporaire 122 et la couche de solidarisation 118.

La poignée temporaire ainsi formée par le substrat temporaire 122 et la couche de solidarisation 118 est utilisée ensuite pour maintenir mécaniquement la structure réalisée lors d'un amincissement du premier substrat 102 depuis sa face arrière 107, comme représenté sur la figure 11. Cet amincissement correspond par exemple à la mise en œuvre d'une CMP. La partie restante du premier substrat 102 sera utilisée pour réaliser le composant 100. L'épaisseur initiale du premier substrat 102 est par exemple égale à environ 725 µm (épaisseur standard d'un substrat de silicium de diamètre égal à 200 µm), et l'épaisseur finale du premier substrat 102 après l'amincissement peut être avantageusement égale à quelques dizaines de microns, notamment inférieure à environ 100 µm. L'épaisseur restante du premier substrat 102 est choisie afin qu'elle corresponde à l'épaisseur souhaitée du composant microélectronique 100. Lorsque le premier substrat 102 a initialement l'épaisseur souhaitée pour le composant 100, cet amincissement n'est pas mis en œuvre.

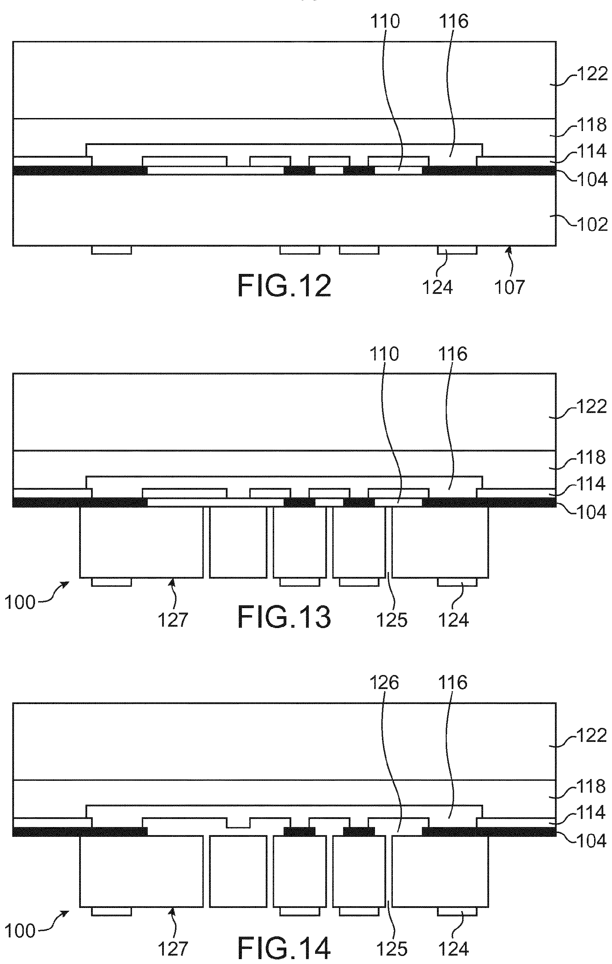

Sur la figure 12, une couche de matériau électriquement conducteur, par exemple métallique, est ensuite déposée sur la face arrière 107 du premier substrat 102, puis gravée telle que des portions restantes de cette couche forment des portions électriquement conductrices 124. Le matériau électriquement conducteur des portions 124 est par exemple de l'aluminium, ce matériau étant adapté pour permettre ensuite la mise en œuvre d'un scellement eutectique AIGe entre ces portions électriquement conductrices 124 et des éléments d'interconnexion électrique auxquels sont reliées les portions 124.

Le premier substrat 102 est ensuite gravé, par exemple par gravure profonde anisotrope de type DRIE, depuis sa face arrière 107 avec arrêt sur la couche de protection 104 et sur les portions restantes 110, formant ainsi les différentes parties du composant microélectroniques 100 (figure 13). Cette gravure forme notamment des tranchées 125 traversant toute l'épaisseur du premier substrat 102 et délimitant les éléments fixes et mobiles du composant 100. Le composant 100 est réalisé tel qu'au moins un élément mobile du composant 100 soit disposé face aux portions restantes 110. Les tranchées 125 forment également des accès depuis une face arrière 127 du composant 100 aux portions restantes 110, 114 de matériau sacrificiel qui sont recouvertes par le capot 116.

Sur la figure 14, les portions restantes 110, 114 de matériau sacrificiel sont gravées grâce aux tranchées 125 depuis la face arrière 127 du composant 100, formant la cavité 126 et libérant également les parties mobiles du composant 100 (par exemple la ou les masses sismiques dans le cas d'un composant 100 correspondant à un accéléromètre). D'autres parties du composant 100 restent solidaires de la couche de protection 104 et/ou du capot 116. Cette gravure peut être réalisée avec une solution d'acide fluorhydrique sous forme liquide ou vapeur lorsque le matériau sacrificiel des portions restantes 110, 114 est du SiO₂. Lorsque le matériau sacrificiel des portions restantes 110, 114 est un polymère, une gravure de type plasma O₂ peut être mise en œuvre. Lors de la gravure du matériau sacrificiel des portions restantes 110, 114, la couche de protection 104 protège certaines des portions restantes 114 disposées en dehors de la cavité 126 ainsi que la couche de solidarisation 118 vis-à-vis de l'agent de gravure utilisé pour supprimer le matériau sacrificiel encapsulé par le capot 116.

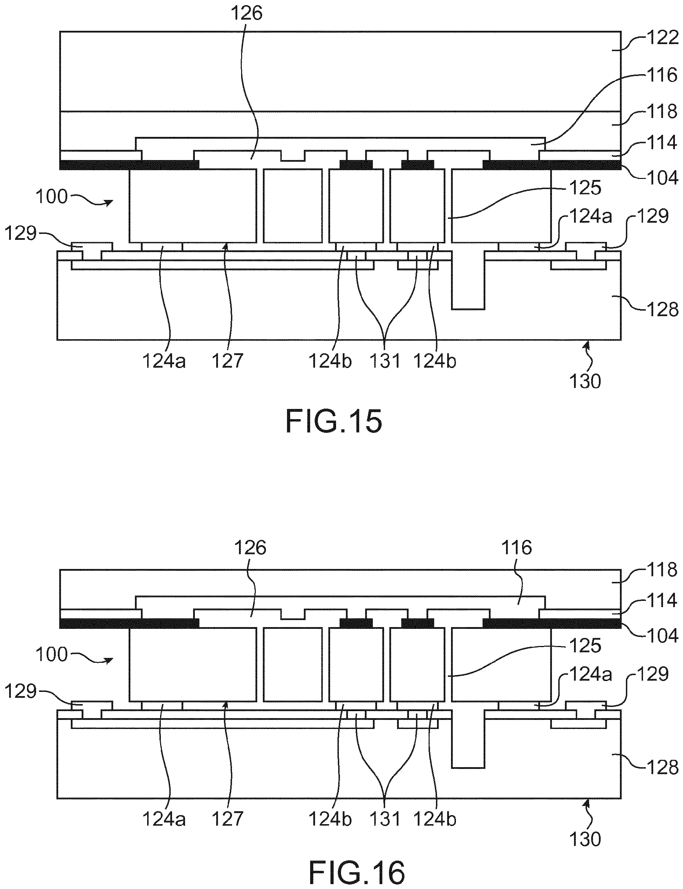

Un deuxième substrat 128 est solidarisé à la face arrière 127 du composant 100 via les portions électriquement conductrices 124 se trouvant sur la face arrière 127 du composant 100. Le deuxième substrat 128 est avantageusement un substrat d'interconnexions permettant un routage des différentes parties électriques du composant 100 vers des plots de contact 129. Ce deuxième substrat 128 peut également correspondre à un circuit électronique apte à lire le ou les signaux électriques délivrés par le composant 100, par exemple de type ASIC. Ce scellement est ici réalisé de manière hermétique afin que le composant 100 se retrouve encapsulé hermétiquement, par exemple dans une atmosphère sous vide ou dans un environnement gazeux neutre, entre le capot 116 et le deuxième substrat 128. Certaines des portions électriquement conductrices 124 auxquelles le deuxième substrat 128 est solidarisé (référencées 124a sur la figure 15) forment un cordon de scellement étanche ou hermétique permettant la fermeture étanche ou hermétique de la cavité 126. D'autres portions électriquement conductrices 124, référencées 124b sur la figure 15, sont solidarisées à des éléments d'interconnexion électrique 131 du deuxième substrat 128 et servent à former des connexions électriques entre le composant 100 et le circuit électronique du deuxième substrat 128. La solidarisation entre le composant 100 et le deuxième substrat 128 est par exemple obtenue par la mise en œuvre d'un scellement eutectique, par exemple de type AuSi, ou par un scellement par thermocompression. Après cette solidarisation, le substrat 128 peut être aminci depuis sa face arrière 130 par exemple par CMP.

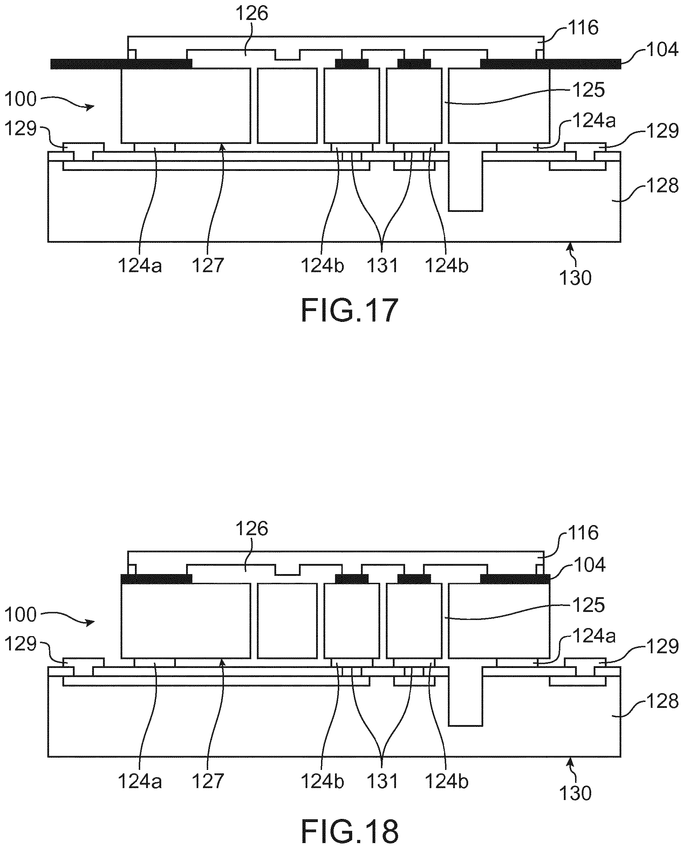

La poignée temporaire est ensuite désolidarisée du reste des éléments en retirant tout d'abord le substrat temporaire 122 (figure 16), puis en gravant la couche de solidarisation 118 (figure 17). Les portions restantes 114 non recouvertes par le capot 116 sont également supprimées, par exemple par gravure. En variante, la désolidarisation du substrat temporaire 122 peut découler directement de la gravure de la couche de solidarisation 118.

Enfin, comme représenté sur la figure 18, le procédé est achevé en gravant les portions de la couche de protection 104 dépassant latéralement du composant 100.

## Revendications

1. Procédé d'encapsulation d'au moins un composant microélectronique (100) de type MEMS et/ou NEMS, comportant au moins la mise en œuvre des étapes suivantes :
- réalisation d'au moins une portion de matériau sacrificiel (110, 114) sur une face avant (106) d'un premier substrat (102) dans lequel le composant microélectronique (100) est apte à être réalisé, puis
- réalisation d'au moins un capot (116) encapsulant au moins la portion de matériau sacrificiel (110, 114), puis
- réalisation du composant microélectronique (100) par gravure du premier substrat (102) depuis une face arrière (107) du premier substrat (102), telle qu'au moins une partie du composant microélectronique (100) soit disposée face à la portion de matériau sacrificiel (110, 114) et que la portion de matériau sacrificiel (110, 114) soit accessible depuis une face arrière (127) du composant microélectronique (100), puis
- élimination de la portion de matériau sacrificiel (110, 114) par gravure depuis la face arrière (127) du composant microélectronique (100), puis
- solidarisation de la face arrière (127) du composant microélectronique (100) avec un deuxième substrat (128).

2. Procédé selon la revendication 1, dans lequel ladite partie du composant microélectronique (100) comporte au moins un élément mobile.

3. Procédé selon l'une des revendications précédentes, dans lequel la gravure mise en œuvre pour réaliser le composant microélectronique (100) dans le premier substrat (102) forme au moins une tranchée (125) traversant toute l'épaisseur du premier substrat (102), délimitant ladite partie du composant microélectronique (100) et formant un accès à la portion de matériau sacrificiel (110, 114) depuis la face arrière (127) du composant microélectronique (100).

4. Procédé selon l'une des revendications précédentes, dans lequel la solidarisation de la face arrière (127) du composant microélectronique (100) avec le deuxième substrat (128) forme au moins une liaison électrique entre au moins un élément d'interconnexion électrique (131) du deuxième substrat (128) et au moins une portion électriquement conductrice (124) du composant microélectronique (100).

5. Procédé selon la revendication 4, dans lequel le deuxième substrat (128) comporte au moins un circuit électronique apte à lire au moins un signal électrique délivré par le composant microélectronique (100).

6. Procédé selon l'une des revendications précédentes, dans lequel la solidarisation de la face arrière (127) du composant microélectronique (100) avec le deuxième substrat (128) est réalisée de manière hermétique telle qu'au moins ladite partie du composant microélectronique (100) soit enfermée hermétiquement dans une cavité (126) formée entre le capot (116) et le deuxième substrat (128).

7. Procédé selon l'une des revendications précédentes, comportant en outre, entre la réalisation du capot (116) et la réalisation du composant microélectronique (100), la mise en œuvre des étapes suivantes :
- réalisation d'une poignée temporaire (118, 122) solidarisée au capot (116) ;
- amincissement du premier substrat (102) tel qu'une épaisseur restante du premier substrat (102) corresponde à une épaisseur du composant microélectronique (100) ;
et dans lequel la poignée temporaire (118, 122) est désolidarisée du capot (116) après la solidarisation de la face arrière (127) du composant microélectronique (100) avec le deuxième substrat (128).

8. Procédé selon la revendication 7, comportant en outre, entre la solidarisation de la face arrière (127) du composant microélectronique (100) avec le deuxième substrat (128) et la désolidarisation de la poignée temporaire (118, 122), la mise en œuvre d'un amincissement du deuxième substrat (128).

9. Procédé selon l'une des revendications 7 ou 8, dans lequel la réalisation de la poignée temporaire (118, 122) comporte la mise en œuvre des étapes suivantes :
- dépôt d'une couche de solidarisation (118) sur le capot (116) et des parties de la face avant (106) du premier substrat (102) non recouvertes par le capot (116) ;
- planarisation de la couche de solidarisation (118) ;
- collage d'un substrat temporaire (122) sur la couche de solidarisation (118).

10. Procédé selon l'une des revendications précédentes, comportant en outre, avant la réalisation du capot (116), la réalisation d'au moins une couche de protection (104) sur la face avant (106) du premier substrat (102), et dans lequel :
- au moins une partie (110) de la portion de matériau sacrificiel (110, 112) est disposée dans au moins une ouverture (105) formée à travers la couche de protection (104) ;
- le matériau de la couche de protection (104) est apte à résister à la gravure mise en œuvre lors de l'élimination de la portion de matériau sacrificiel (110, 114).

11. Procédé selon les revendications 9 et 10, dans lequel le matériau de la couche de protection (104) est apte à protéger la couche de solidarisation (118) lors de la gravure mise en œuvre lors de l'élimination de la portion de matériau sacrificiel (110, 114).

12. Procédé selon l'une des revendications 10 ou 11, dans lequel la couche de protection (104) est réalisée sur la face avant (106) du premier substrat (102) avant la réalisation de la portion de matériau sacrificiel (110, 114), et dans lequel la réalisation de la portion de matériau sacrificiel (110, 114) comporte la mise en œuvre des étapes suivantes :
- dépôt d'au moins une première couche de matériau sacrificiel (108) sur la couche de protection (104) et dans ladite au moins une ouverture (105) formée à travers la couche de protection (104) ;
- planarisation de la première couche de matériau sacrificiel (108) avec arrêt sur la couche de protection (104), formant au moins une portion restante (110) de la première couche de matériau sacrificiel (108) disposée dans ladite au moins une ouverture (105) formée à travers la couche de protection (104) ;
- dépôt d'au moins une deuxième couche de matériau sacrificiel (112) sur ladite au moins une portion restante (110) de la première couche de matériau sacrificiel (108) et sur la couche de protection (104) ;
- gravure de la deuxième couche de matériau sacrificiel (112) telle que des portions restantes (114) de la deuxième couche de matériau sacrificiel (112) définissent au moins une zone d'ancrage du capot (116) au premier substrat (102) et au moins une butée pour au moins un élément mobile du composant microélectronique (100), et telle qu'au moins une des portions restantes (114) de la deuxième couche de matériau sacrificiel (112) recouvre au moins en partie ladite au moins une portion restante (110) de la première couche de matériau sacrificiel (108) ;
et dans lequel la portion de matériau sacrificiel (110, 114) encapsulée par le capot (116) correspond à ladite au moins une portion restante (110) de la première couche de matériau sacrificiel (108) et aux portions restantes (114) de la deuxième couche de matériau sacrificiel (112).

13. Procédé selon l'une des revendications précédentes, dans lequel la réalisation du capot (116) comporte une étape de dépôt d'une couche d'encapsulation d'épaisseur inférieure à environ 10 µm.

## Patentansprüche

1. Verfahren zur Einkapselung wenigstens eines mikroelektronischen Bauteils (100) vom Typ MEMS und/oder NEMS, umfassend wenigstens die Durchführung der folgenden Schritte:
- Realisieren wenigstens eines Bereichs aus Opfermaterial (110, 114) auf einer Vorderfläche (106) eines ersten Substrats (102), in dem das mikroelektronische Bauteil (100) realisiert werden kann, und dann
- Realisieren wenigstens einer Kappe (116), die wenigstens den Bereich aus Opfermaterial (110, 114) einkapselt, und dann
- Realisieren des mikroelektronischen Bauteils (100) durch Ätzen des ersten Substrats (102) von einer Rückfläche (107) des ersten Substrats (102) aus derart, dass wenigstens ein Teil des mikroelektronischen Bauteils (100) gegenüber dem Bereich aus Opfermaterial (110, 114) angeordnet ist, und dass der Bereich aus Opfermaterial (110, 114) von einer Rückfläche (127) des mikroelektronischen Bauteils (100) aus zugänglich ist, und dann
- Entfernen des Bereichs aus Opfermaterial (110, 114) durch Ätzen von der Rückfläche (127) des mikroelektronischen Bauteils (100) aus, und dann
- Verbinden der Rückfläche (127) des mikroelektronischen Bauteils (100) mit einem zweiten Substrat (128).

2. Verfahren nach Anspruch 1, bei dem der Teil des mikroelektronischen Bauteils (100) wenigstens ein bewegliches Element umfasst.

3. Verfahren nach einem der vorhergehenden Ansprüche, bei dem das Ätzen, das durchgeführt wird, um das mikroelektronische Bauteil (100) in dem ersten Substrat (102) zu realisieren, wenigstens einen Graben (125) bildet, der die gesamte Dicke des ersten Substrats (102) durchsetzt, den Teil des mikroelektronischen Bauteils (100) begrenzt und einen Zugang zu dem Bereich aus Opfermaterial (110, 114) von der Rückfläche (127) des mikroelektronischen Bauteils (100) aus bildet.

4. Verfahren nach einem der vorhergehenden Ansprüche, bei dem die Verbindung der Rückfläche (127) des mikroelektronischen Bauteils (100) mit dem zweiten Substrat (128) wenigstens eine elektrische Verbindung bildet zwischen wenigstens einem elektrischen Zwischenverbindungselement (131) des zweiten Substrats (128) und wenigstens einem elektrisch leitenden Bereich (124) des mikroelektronischen Bauteils (100).

5. Verfahren nach Anspruch 4, bei dem das zweite Substrat (128) wenigstens eine elektronische Schaltung umfasst, die dazu ausgelegt ist, wenigstens ein elektrisches Signal zu lesen, das durch das mikroelektronische Bauteil (100) geliefert wird.

6. Verfahren nach einem der vorhergehenden Ansprüche, bei dem die Verbindung der Rückfläche (127) des mikroelektronischen Bauteils (100) mit dem zweiten Substrat (128) in hermetischer Weise derart realisiert wird, dass wenigstens der Teil des mikroelektronischen Bauteils (100) hermetisch in einem Hohlraum (126) eingeschlossen ist, der zwischen der Kappe (116) und dem zweiten Substrat (128) gebildet ist.

7. Verfahren nach einem der vorhergehenden Ansprüche, ferner umfassend zwischen der Realisierung des Deckels (116) und der Realisierung des mikroelektronischen Bauteils (100) die Durchführung der folgenden Schritte:
- Realisieren eines temporären Griffs (118, 122), der mit der Kappe (116) verbunden ist;
- Abdünnen des ersten Substrats (102) derart, dass eine verbleibende Dicke des ersten Subtrats (102) einer Dicke des mikroelektronischen Bauteils (100) entspricht;
und bei dem der temporäre Griff (118, 122) nach der Verbindung der Rückfläche (127) des mikroelektronischen Bauteils (100) mit dem zweiten Substrat (128) von der Kappe (116) gelöst wird.

8. Verfahren nach Anspruch 7, ferner umfassend zwischen der Verbindung der Rückfläche (127) des mikroelektronischen Bauteils (100) mit dem zweiten Substrat (128) und dem Lösen des temporären Griffs (118, 122) die Durchführung eines Abdünnens des zweiten Substrats (128).

9. Verfahren nach einem der Ansprüche 7 oder 8, bei dem das Realisieren des temporären Griffs (118, 122) die Durchführung der folgenden Schritte umfasst:
- Aufbringen einer Verbindungsschicht (118) auf der Kappe (116) und Teilen der Vorderfläche (106) des ersten Substrats (102), die nicht durch die Kappe (116) bedeckt sind;
- Planarisieren der Verbindungsschicht (118);
- Kleben eines temporären Substrats (122) auf die Verbindungsschicht (118).

10. Verfahren nach einem der vorhergehenden Ansprüche, ferner umfassend vor der Realisierung der Kappe (116) die Realisierung wenigstens einer Schutzschicht (104) auf der Vorderfläche (106) des ersten Substrats (102), und bei dem:
- wenigstens ein Teil (110) des Bereichs aus Opfermaterial (110, 112) in wenigstens einer Öffnung (105) angeordnet wird, die durch die Schutzschicht (104) hindurch gebildet wird;
- das Material der Schutzschicht (104) dazu ausgelegt ist, der Ätzung zu widerstehen, die während des Entfernens des Bereichs aus Opfermaterial (110, 114) durchgeführt wird.

11. Verfahren nach den Ansprüchen 9 und 10, bei dem das Material der Schutzschicht (104) dazu ausgelegt ist, die Verbindungsschicht (118) während des Ätzens zu schützen, das während des Entfernens des Bereichs aus Opfermaterial (110, 114) durchgeführt wird.

12. Verfahren nach einem der Ansprüche 10 oder 11, bei dem die Schutzschicht (104) auf der Vorderfläche (106) des ersten Substrats (102) vor der Realisierung des Bereichs aus Opfermaterial (110, 114) realisiert wird, und bei dem die Realisierung des Bereichs aus Opfermaterial (110, 114) die Durchführung der folgenden Schritte umfasst:
- Aufbringen wenigstens einer ersten Schicht aus Opfermaterial (108) auf der Schutzschicht (104) und in der wenigstens einen Öffnung (105), die durch die Schutzschicht (104) hindurch gebildet ist;
- Planarisieren der ersten Schicht aus Opfermaterial (108) mit einem Stopp auf der Schutzschicht (104), wodurch wenigstens ein verbleibender Bereich (110) der ersten Schicht aus Opfermaterial (108) gebildet wird, der in der wenigstens einen Öffnung (105) angeordnet ist, die durch die Schutzschicht (104) hindurch gebildet ist;
- Aufbringen wenigstens einer zweiten Schicht aus Opfermaterial (112) auf dem wenigstens einen verbleibenen Bereich (110) der ersten Schicht aus Opfermaterial (108) und auf der Schutzschicht (104);
- Ätzen der zweiten Schicht aus Opfermaterial (112) derart, dass verbleibende Bereiche (114) der zweiten Schicht aus Opfermaterial (112) wenigstens eine Zone zur Verankerung der Kappe (116) an dem ersten Substrat (102) und wenigstens einen Anschlag für wenigstens ein bewegliches Element des mikroelektronischen Bauteils (100) definieren, und derart, dass wenigstens einer der verbleibenden Bereiche (114) der zweiten Schicht aus Opfermaterial (112) wenigstens teilweise den wenigstens einen verbleibenden Bereich (110) der ersten Schicht aus Opfermaterial (108) bedeckt;
und bei dem der Bereich aus Opfermaterial (110, 114), der durch die Kappe (116) eingekapselt ist, dem wenigstens einen verbleibenden Bereich (110) der ersten Schicht aus Opfermaterial (108) und den verbleibenden Bereichen (114) der zweiten Schicht aus Opfermaterial (112) entspricht.

13. Verfahren nach einem der vorhergehenden Ansprüche, bei dem die Realisierung der Kappe (116) einen Schritt des Aufbringens einer Einkapselungsschicht mit einer Dicke von weniger als ungefähr 10 µm umfasst.

## Claims

1. Method for encapsulation of at least one microelectronic component (100) of MEMS and/or NEMS type, comprising at least the implementation of the following steps :
- making of at least one portion of sacrificial material (110, 114) on a front face (106) of a first substrate (102) in which the microelectronic component (100) is intended to be made, then
- making of at least one cover (116) encapsulating at least the portion of sacrificial material (110, 114), then
- making of the microelectronic component (100) by etching the first substrate (102) from a back face (107) of the first substrate (102), such that at least part of the microelectronic component (100) is arranged to face the portion of sacrificial material (110, 114) and such that the portion of sacrificial material (110, 114) is accessible from a back face (127) of the microelectronic component (100), then
- elimination of the portion of sacrificial material (110, 114) by etching from the back face (127) of the microelectronic component (100), then
- securing of the back face (127) of the microelectronic component (100) to a second substrate (128).

2. Method according to claim 1, in which said part of the microelectronic component (100) comprises at least one mobile element.

3. Method according to one of previous claims, in which the etching used to make the microelectronic component (100) in the first substrate (102) forms at least one trench (125) passing through the entire thickness of the first substrate (102), delimits said part of the microelectronic component (100) and forms an access to the portion of sacrificial material (110, 114) from the back face (127) of the microelectronic component (100).

4. Method according to one of previous claims, in which the securing of the back face (127) of the microelectronic component (100) to the second substrate (128) forms at least one electrical bond between at least one electrical interconnection element (131) of the second substrate (128) and at least one electrically conducting portion (124) of the microelectronic component (100).

5. Method according to claim 4, in which the second substrate (128) comprises at least one electronic circuit capable of reading at least one electrical signal outputted by the microelectronic component (100).

6. Method according to one of previous claims, in which the securing of the back face (127) of the microelectronic component (100) to the second substrate (128) is made hermetically such that at least said part of the microelectronic component (100) is hermetically enclosed in a cavity (126) formed between the cover (116) and the second substrate (128).

7. Method according to one of previous claims, also comprising, between the making of the cover (116) and the making of the microelectronic component (100), the implementation of the following steps:
- making of a temporary handle (118, 122) secured to the cover (116);
- thinning of the first substrate (102) such that a remaining thickness of the first substrate (102) corresponds to a thickness of the microelectronic component (100);
and in which the temporary handle (118, 122) is decoupled from the cover (116) after the back face (127) of the microelectronic component (100) has been secured to the second substrate (128).

8. Method according to claim 7, also comprising, between the securing of the back face (127) of the microelectronic component (100) to the second substrate (128) and the decoupling of the temporary handle (118, 122), the implementation of a thinning of the second substrate (128).

9. Method according to one of claims 7 or 8, in which the making of the temporary handle (118, 122) includes the implementation of the following steps:
- deposition of a securing layer (118) on the cover (116) and parts of the front face (106) of the first substrate (102) not covered by the cover (116);
- planarization of the securing layer (118);
- bonding of a temporary substrate (122) on the securing layer (118).

10. Method according to one of previous claims, also comprising a making of at least one protection layer (104) on the front face (106) of the first substrate (102) before the making of the cover (116), and in which:
- at least part (110) of the portion of sacrificial material (110, 112) is arranged in at least one opening (105) made through the protection layer (104);
- the material of the protection layer (104) is able to resist against the etching carried out during elimination of the portion of sacrificial material (110, 114).

11. Method according to claims 9 and 10, in which the material of the protection layer (104) is able to protect the securing layer (118) during the etching carried out during elimination of the portion of sacrificial material (110, 114).

12. Method according to one of claims 10 or 11, in which the protection layer (104) is made on the front face (106) of the first substrate (102) before the making of the portion of sacrificial material (110, 114), and in which the making of the portion of sacrificial material (110, 114) comprises the implementation of the following steps:
- deposition of at least a first layer of sacrificial material (108) on the protection layer (104) and in said at least one opening (105) made through the protection layer (104);
- planarization of the first layer of sacrificial material (108) with stoppage on the protection layer (104), forming at least one remaining portion (110) of the first layer of sacrificial material (108) arranged in said at least one opening (105) formed through the protection layer (104);
- deposition of at least one second layer of sacrificial material (112) on said at least one remaining portion (110) of the first layer of sacrificial material (108) and on the protection layer (104);
- etching of the second layer of sacrificial material (112) such that the remaining portions (114) of the second layer of sacrificial material (112) define at least one zone in which the cover (116) is anchored to the first substrate (102) and at least one stop for at least one mobile element of the microelectronic component (100), and such that at least one of the remaining portions (114) of the second layer of sacrificial material (112) at least partially covers said at least one remaining portion (110) of the first layer of sacrificial material (108);
and in which the portion of sacrificial material (110, 114) encapsulated by the cover (116) corresponds to said at least one remaining portion (110) of the first layer of sacrificial material (108) and the remaining portions (114) of the second layer of sacrificial material (112).

13. Method according to one of previous claims, in which the making of the cover (116) comprises a deposition of an encapsulation layer with a thickness of less than about 10 µm.
